(19) Europäisches Patentamt
European Patent Office
Office européen des brevets

(11) **EP 4 628 905 A1**

(12) **EUROPÄISCHE PATENTANMELDUNG**

(43) Veröffentlichungstag:
**08.10.2025 Patentblatt 2025/41**

(21) Anmeldenummer: **25164069.4**

(22) Anmeldetag: **17.03.2025**

(51) Internationale Patentklassifikation (IPC):
**G01R 27/02** $^{(2006.01)}$ **G01R 27/08** $^{(2006.01)}$

(52) Gemeinsame Patentklassifikation (CPC):
**G01R 27/025; G01R 27/08**

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**
Benannte Erstreckungsstaaten:
**BA**
Benannte Validierungsstaaten:
**GE KH MA MD TN**

(30) Priorität: **27.03.2024 AT 502682024**

(71) Anmelder: **AVL DiTest GmbH**
**8020 Graz (AT)**

(72) Erfinder:
• **Fischer, Lukas**
**6071 Aldrans (AT)**
• **Riegler, Roman**
**6075 Tulfes (AT)**
• **Schulz, Jonas**
**8041 Graz (AT)**

(74) Vertreter: **Patentanwälte Pinter & Weiss OG**
**Prinz-Eugen-Straße 70**
**1040 Wien (AT)**

(54) **ERMITTELN EINES ISOLATIONSWIDERSTANDS**

(57) Um die Auswirkungen von Schwankungen eines Messstroms ($i_m$) auf die Ermittlung eines Isolationswiderstands (R) in einem Hochvolt-System erheblich und effektiv zu reduzieren, wird ein Verfahren zum Ermitteln eines Isolationswiderstands (R) in einem Hochvolt-System (2) sowie eine zugehöriges Messsystem vorgeschlagen, bei welchen während eines Hochlaufens (LP) einer Testspannung auf einen vorgegebenen Sollwert ($U_t$) zuerst eine elektrische Ladung des zu testenden Hochvolt-Systems (2) und/oder der zu testenden Komponente ermittelt wird (101) und dann aus der ermittelten Ladung ein Kapazitätswert (C) für das zu testenden Hochvolt-System (2) und/oder die zu testenden Komponente abgeschätzt wird (102), und bei welchem während einer Messphase (MP), in welcher von der Testspannung der vorgegebenen Sollwert ($U_t$) erreicht und annähernd eingehalten wird, aus dem abgeschätzten Kapazitätswert (C) und aus einer zeitlichen Abweichung einer gemessenen Messspannung ($u_m$) von dem vorgegebenen Sollwert ($U_t$) der Testspannung ein Korrekturstrom ($i_{dr}$) ermittelt wird (103), mit welchem der jeweils gemessene Messstrom ($i_m$) korrigiert wird, und dann aus dem korrigierten Messstrom ($i_{korr}$) und der gemessenen Messspannung ($u_m$) der Isolationswiderstand (R) abgeleitet wird (104). Zumindest der abgeleitete Isolationswiderstand (R) kann dann ausgegeben und angezeigt werden (105).

**Fig. 2**

EP 4 628 905 A1

## Beschreibung

Die vorliegende Erfindung betrifft ein Verfahren zum Ermitteln eines Isolationswiderstands in einem Hochvolt-System sowie ein zugehöriges Messsystem zum Ermitteln eines Isolationswiderstands. Dabei wird eine Testspannung mit einem vorgegebenen konstanten Sollwert an das zu testende Hochvolt-System und/oder eine zu testende Komponente angelegt und es werden ein durch die Testspannung hervorgerufener Messstrom und eine aktuell am zu testenden Hochvolt-System und/oder an der zu testenden Komponente anliegende Messspannung gemessen.

### Stand der Technik

Hochvolt-Komponenten bzw. HV-Komponenten, wie z.B. wiederaufladbare Batterien (Hochvolt-Batterie), Leistungselektronik-Komponenten (z.B. einen Wechselrichter zur Ansteuerung der elektrischen Antriebsmaschine, einen Spannungswandler bzw. DC-DC-Wandler, etc.), On-Board-Charger (OBC) und weitere Nebenaggregate (z.B. Pumpen, Heizelemente, etc.), welche mit der leistungsfähigen Hochvolt-Batterie über eine Vielzahl von Hochvolt-Leitungen elektrisch leitend verbunden sind, werden beispielsweise in elektrifizierten Fahrzeugen eingesetzt. Diese HV-Komponenten bilden das so genannte Hochvolt-System bzw. HV-System des elektrifizierten Fahrzeugs, welches meist mit einer Betriebsspannung von über 60 V, üblicherweise in einem Bereich von mehreren 100 Volt (z.B. zwischen 200 V bis 1 kV), betrieben wird. Die HV-Batterie sowie die angeschlossenen HV-Komponenten sind daher elektrisch gegenüber anderen Fahrzeugteilen, insbesondere gegenüber dem Chassis des Fahrzeugs, isoliert. Zumeist ist das HV-System eines elektrifizierten Fahrzeugs als nicht geerdetes, sogenanntes IT (Isolé Terre)-Netz umgesetzt und üblicherweise komplett galvanisch getrennt von einem Fahrzeugbezugspotential bzw. Fahrzeugmasse.

Durch einen hinreichend großen Widerstand der Isolation des HV-Systems bzw. der HV-Komponenten, insbesondere der HV-Kabel und gegebenenfalls der HV-Steckverbindungen, welche die Komponenten verbinden, werden unerwünschten Stromflüsse verhindert und Personen im Umfeld eines elektrifizierten Fahrzeugs vor einem entsprechenden Kontakt mit dem HV-System geschützt. Üblicherweise liegt der Isolationswiderstand in einem Bereich von hundert Megaohm bis Gigaohm, damit keine Gefährdung besteht. Isolationswiderstände können sich allerdings durch Alterungsprozesse, Feuchtigkeit, Verschmutzung, Beschädigung, Strahlung und chemische oder physikalische Einflüsse verändern. Damit keine Gefährdung besteht, sind Mindestisolationswiderstände vorgeschrieben. Daher werden HV-Systeme in elektrifizierten Fahrzeugen beispielsweise während des Betriebs von eingebauten automatischen Isolationswächtern überwacht, um eventuelle Fehlerströme zu erkennen und eine potentielle Gefährdung für den Nutzer zu verhindern. Weiterhin wird der Zustand der Isolation des HV-Systems durch eine Isolationsmessung, z.B. bei einem Wartungsservice, überprüft, wobei zumeist ein Isolationswiderstand des HV-Systems bzw. einzelner HV-Komponenten (z.B. HV-Kabel, Ladebuchse, Leistungselektronik, etc.) mit einem Messsystem, beispielsweise mit einem Isolationsmessgerät, ermittelt wird, welches über Messkontakte mit dem überprüfenden HV-System bzw. mit der zu überprüfenden HV-Komponente verbindbar ist. Die Messung des Isolationswiderstands dient üblicherweise einer qualitativen Bewertung des Zustands der Isolation des HV-Systems, insbesondere der HV-Kabel und der Isolierung im Inneren des HV-Systems.

Um die Integrität der Isolation im HV-System zu überprüfen, wird üblicherweise eine konstante Gleichspannung als Testspannung an das zu testende HV-System bzw. an eine zu testende HV-Komponente angelegt. Die Testspannung sollte dabei zumindest im Bereich der Batteriespannung des elektrifizierten Fahrzeugs, idealerweise leicht darüber, liegen. Typischerweise wird eine Testspannung mit einem vorgegebenen Sollwert von 500 Volt verwendet. Ein durch die angelegte Testspannung hervorgerufener Strom, ein sogenannter Leckstrom, wird dann gemessen, um den Isolationswiderstand aus dem Wert der angelegten Testspannung und dem gemessenen Leckstrom abzuleiten. Dabei weist der gemessene Strom in einer Anfangsphase der Messung, in welcher z.B. die Testspannung auf den vorgegebenen Wert hochläuft, neben dem Leckstrom üblicherweise parasitäre Stromanteile auf. Die parasitären Stromanteile umfassen z.B. einen kapazitiven Stromanteil oder Ladestrom, welcher insbesondere einen Strom zum Laden oder Umladen der Kapazitäten im HV-System bzw. der Isolierung umfasst, und einen absorptiven Stromanteil, welcher aufgrund einer Umorientierung von Molekülen im Isolationsmaterial der Isolierung fließt. Diese parasitären Stromanteile können im Vergleich zum Leckstrom relativ hoch sein, fallen aber üblicherweise relativ schnell (z.B. exponentiell) ab. Erst nach einer Abklingzeit entspricht der gemessene Strom dem Leckstrom und der Isolationswiderstand kann ermittelt werden.

In Systemen mit relativ hohen Betriebsspannungen, wie z.B. in HV-Systemen, fließt allerdings ein relativ kleiner Leckstrom, beispielsweise in einem Bereich von einigen Mikroampere oder zumeist darunter, durch die Isolierung hindurch. Diese sehr kleinen Leckströme müssen vom Messsystem bzw. vom Isolationsmessgerät quantifiziert werden. Dieses Messsystem stellt z.B. ein multifunktionales Messgerät dar und weist neben einer einstellbaren oder geregelten Spannungsquelle als Spannungsgenerator, von welcher die Testspannung mit einem vorgegebenen konstanten Sollwert generiert wird, zumindest ein Strommessgerät auf, mit welchem der durch die Testspannung hervorgerufene Strom gemessen werden kann, um den Isolationswiderstands zu ermitteln. Zusätzlich kann das Messsystem auch ein Spannungsmessgerät aufweisen, um beispielsweise ein am zu testenden HV-System bzw. an der zu testenden HV-Komponente anliegende Spannung bzw. deren Verlauf, vor allem beim Hochlaufen der Testspannung, zu messen.

Im Fall von Kapazitäten, insbesondere von relativ großen Kapazitäten, im zu testenden HV-System kann eine Regulierung der Testspannung auf den gewünschten konstanten Sollwert schwierig sein. Vor allem wenn die Testspannung beispielsweise von einer geregelte Spannungsquelle bzw. mittels eines Spannungsreglers als Spannungsgenerator erzeugt wird und auf den gewünschten konstanten Sollwert geregelt werden soll, können beispielsweise Driftspannungen und/oder Schwankungen in der Testspannung auftreten. Diese Driftspannungen sind relativ langsam und werden z.B. durch ein niederfrequentes Rauschen (z.B. 1/f-Rauschen) in der Rückkopplungsregelung der Spannungsquelle verursacht. Das bedeutet, dass die Testspannung neben einem Gleichspannungsanteil, welcher dem vorgegebenen Sollwert entsprecht, einen durch die Driftspannungen und/oder Schwankungen bewirkten, niederfrequenten Wechselspannungsanteil aufweist. Durch den niederfrequenten Wechselspannungsanteil, mit welchem die Testspannung vom Sollwert abweicht, können durch die Kapazitäten im zu testenden HV-System relativ große kapazitive Stromanteile bzw. Ladeströme entstehen, welche den relativ kleinen Leckstrom überdecken. Die Messung des Leckstroms wird dadurch verfälscht und eine korrekte Bestimmung des Isolationswiderstands des zu testenden HV-Systems dadurch erheblich behindert.

### Darstellung der Erfindung

Der Erfindung liegt daher die Aufgabe zugrunde, ein Verfahren sowie eine zugehörige Vorrichtung anzugeben, mit welchen ein Isolationswiderstand in einem HV-System und/oder einer HV-Komponente möglichst korrekt und unverfälscht ermittelt werden kann.

Diese und weitere Aufgaben werden durch ein Verfahren sowie eine Messvorrichtung gemäß den unabhängigen Ansprüchen gelöst. Vorteilhafte Ausführungsformen der vorliegenden Erfindung sind in den abhängigen Ansprüchen beschrieben.

Erfindungsgemäß erfolgt die Lösung der Aufgabe durch ein Verfahren der eingangs angegebenen Art, wobei während eines Hochlaufens der Testspannung auf einen vorgegebenen konstanten Sollwert eine elektrische Ladung des zu testenden Hochvolt-Systems und/oder der zu testenden Komponente ermittelt wird, wobei weiterhin aus der ermittelten Ladung ein Kapazitätswert für das zu testenden Hochvolt-System und/oder für die zu testenden Komponente abgeschätzt wird, wobei dann während einer Messphase aus dem abgeschätzten Kapazitätswert und aus einer zeitlichen Abweichung der gemessenen Messspannung vom vorgegebenen Sollwert der Testspannung ein Korrekturstrom ermittelt wird, mit welchem der jeweils gemessene Messstrom korrigiert wird, und wobei aus dem korrigierten Messstrom und der gemessenen Messspannung der Isolationswiderstand abgeleitet wird. Dadurch werden die - insbesondere durch die Spannungsdrift der Testspannung verursachten - Schwankungen des Messstroms erheblich und effektiv reduziert. Der Isolationswiderstand des zu testenden HV-Systems bzw. der zu testenden HV-Komponente kann damit wesentlich genauer und weitgehend unverfälscht ermittelt werden, da der Korrekturstrom einen Einfluss der durch die Spannungsdrift verursachten Ladeströme bzw. Schwankungen im Messstrom weitgehend kompensiert.

Idealerweise wird die elektrische Ladung des zu testenden HV-Systems und/oder der zu testenden Komponente durch Aufintegrieren des gemessenen Messstroms während des Hochlaufens der Testspannung auf den vorgegebenen konstanten Sollwert ermittelt, um aus der elektrischen Ladung einen Kapazitätswert des zu testenden HV-Systems und/oder der zu testenden Komponente abzuschätzen. Dazu kann in einer bevorzugten Ausführung des erfindungsgemäßen Verfahrens ein erster und ein zweiter Spannungswert der Messspannung vorgegebenen werden, zwischen welchen die elektrische Ladung des zu testenden Hochvolt-Systems und/oder der zu testenden Komponente ermittelt wird. D.h., während des Hochlaufens der Testspannung wird beim Erreichen des ersten Spannungswerts durch die Messspannung mit der Aufintegration des Messstroms begonnen und beim Erreichen des zweiten Spannungswert durch die Messspannung diese wieder beendet und dadurch die Aufladung oder Entladung des zu testenden HV-Systems bzw. der zu testenden Komponente, welche durch das Anlegen und Hochlaufen der Testspannung bewirkt wird, ermittelt, um daraus die Kapazität des zu testenden HV-Systems bzw. der zu testenden Komponente abzuschätzen.

Eine weitere Ausführungsvariante des erfindungsgemäßen Verfahrens sieht vor, dass für das Abschätzen des Kapazitätswerts des zu testenden Hochvolt-Systems und/oder der zu testenden Komponente ein dritter Spannungswert der Messspannung vorgegeben wird, welcher größer als der erste Spannungswert der Messspannung und kleiner als der zweite Spannungswert der Messspannung ist. Dabei wird dann jeweils die elektrische Ladung des zu testenden Hochvolt-Systems und/oder der zu testenden Komponente zwischen dem ersten und dem dritten Spannungswert und die elektrische Ladung des zu testenden Hochvolt-System und/oder der zu testenden Komponente zwischen dem dritten und dem zweiten Spannungswert ermittelt wird und jeweils aus den ermittelten Ladungen ein jeweiliger Kapazitätswert des zu testenden Hochvolt-Systems und/oder der zu testende Komponente abgeschätzt. Daraus kann z.B. ein Einfluss eines parallelen Widerstands festgestellt werden bzw. die Genauigkeit der Abschätzung des Kapazitätswerts des zu testenden HV-Systems und/oder der zu testenden Komponente sehr einfach verbessert werden.

Es ist weiterhin günstig, wenn zumindest der abgeleitete Isolationswiderstand ausgegeben und dargestellt wird. Dazu kann in einem Messsystem zum Ermitteln des Isolationssystems eine Anzeigeeinheit vorgesehen sein.

Idealerweise werden eine Messung des Messstroms und eine Messung der Messspannung simultan durchgeführt. Dadurch wird beispielsweise das Abschätzen der Kapazität durch das Aufintegrieren des Messstroms und ein laufendes Korrigieren des Messstroms sowie ein Ermitteln des Isolationswiderstands wesentlich vereinfacht.

Es ist auch günstig, wenn während des Hochlaufens der Testspannung auf den vorgegebenen konstanten Sollwert eine zeitliche Änderung der am zu testenden Hochvolt-System und/oder an der zu testenden Komponente anliegenden Messspannung beim Hochlaufen der Testspannung auf den vorgegebenen Sollwert begrenzt wird.

Die Messung des Messstrom und/oder der Messspannung kann entweder kontinuierlich oder mittels zeitdiskreter Abtastung erfolgen. Insbesondere bei einer zeitdiskreten Abtastung des Messstrom kann dieser während des Hochlaufens der Testspannung besonders einfach aufintegriert werden.

Die Lösung der Aufgabe erfolgt weiterhin durch ein Messsystem zum Ermitteln eines Isolationswiderstands in einem Hochvolt-System. Das Messsystem ist dazu mit dem zu testenden Hochvolt-System und/oder mit einer zu testenden Komponente des Hochvolt-Systems verbindbar und weist zumindest eine Spannungsquelle zum Generieren einer Testspannung mit einem vorgegebenen konstanten Sollwert, ein Strommessgerät zum Messen eines durch die Testspannung hervorgerufenen Messstrom und ein Spannungsmessgerät zum Messen einer am zu testenden Hochvoltsystem und/oder der zu testenden Komponente anliegenden Messspannung auf. Weiterhin weist das Messsystem eine Auswerteeinheit auf, welche dazu eingerichtet ist, während eines Hochlaufens der Testspannung auf den vorgegebenen konstanten Sollwert eine elektrische Ladung des zu testenden Hochvolt-Systems und/oder der zu testenden Komponente zu ermitteln und aus der ermittelten Ladung einen Kapazitätswert des zu testenden Hochvolt-Systems und/oder der zu testenden Komponente abzuschätzen. Dies kann z.B. mittels Aufintegrieren des gemessenen Messstroms, idealerweise zwischen einem ersten und zweiten Spannungswert der Messspannung, erfolgen. Weiterhin ist die Auswerteeinheit dazu eingerichtet, während einer Messphase aus dem ermittelten Kapazitätswert und aus einer zeitlichen Abweichung der vom Spannungsmessgerät gemessenen Messspannung vom vorgegebenen konstanten Sollwert der Testspannung ein Korrekturstrom zum Korrigieren des vom Strommessgerät gemessenen Messstroms zu ermitteln und aus dem korrigierten Messstrom und der gemessenen Messspannung den Isolationswiderstand abzuleiten.

Es ist dabei vorteilhaft, wenn eine Messwerterfassung durch das Strommessgerät und eine Messwerterfassung durch das Spannungsmessgerät sowie die Auswerteeinheit Mikrokontroller basiert ausgestaltet sind. Dadurch kann die Durchführung des erfindungsgemäßen Verfahrens beispielsweise annähernd in Echtzeit erfolgen.

*Kurzbeschreibung der Figuren*

Die gegenständliche Erfindung wird nachfolgend unter Bezugnahme auf die Figuren 1 bis 4 näher erläutert, die beispielhaft, schematisch und nicht einschränkend vorteilhafte Ausgestaltungen der Erfindung zeigen. Dabei zeigt

Fig.1 ein Messsystem zum Ermitteln eines Isolationswiderstands in einem Hochvolt-System

Fig.2 einen Ablauf des Verfahrens zum Ermitteln eines Isolationswiderstands in einem Hochvolt-System

Fig.3 einen Verlauf einer gemessenen Messspannung während des Verfahrens zum Ermitteln des Isolationswiderstands im Hochvolt-System

Fig.4 Verläufe der gemessenen Messspannung sowie von einem gemessenen Messstrom, einem Korrekturstrom und einem korrigierten Messstrom und von einem abgeleiteten Widerstand während einer Messphase

*Ausführung der Erfindung*

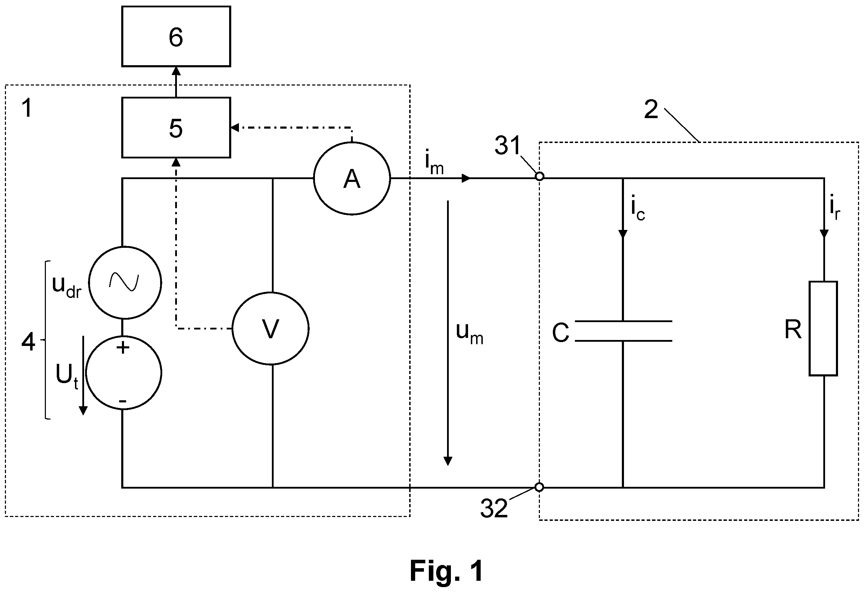

Figur 1 zeigt beispielhaft und schematisch ein Messsystem 1, mit welchem ein Isolationswiderstand R in einem Hochvolt-System 2 bzw. in einem HV-System 2 ermittelt werden kann. Das zu testende HV-System 2 bzw. die zu testende Komponente 2 (z.B. HV-Kabel, Ladebuchse, Leistungselektronik, etc.) des HV-Systems ist dabei als Parallelschaltung einer Kapazität C und eines Widerstands R dargestellt, wobei der Widerstand R den zu messenden Isolationswiderstand R symbolisiert und die Kapazität C für die Kapazitäten im HV-System 2 bzw. in HV-Komponente 2 steht. Das Messsystem 1 ist über Messkontakte 31, 32 mit dem zu testenden HV-System 2 bzw. der zu testenden HV-Komponente 2 verbindbar. Die Messkontakte 31, 31 können z.B. als Prüfspitzen ausgestaltet sein, welche mit Messpunkten (z.B. positiver Hochvolt-Anschluss des zu testenden HV-Systems 2 bzw. der zu testenden Komponente und Chassis als Bezugspotential, negativer Hochvolt-Anschluss des zu testenden HV-Systems 2 bzw. der zu testenden Komponente und Chassis als Bezugspotential) in Verbindung gebracht werden. Die Messkontakte 31, 32 können aber auch als Anschlüsse und/oder Klemmen ausgestaltet werden, um z.B. an einen passende Messbuchse (z.B. HV+-Buchse, HV--Buchse) angeschlossen oder auf einem Messpunkt (z.B. Chassis des Fahrzeugs) geklemmt zu werden.

Weiterhin weist das Messsystem 1 eine Spannungsquelle 4 auf, von welcher eine Testspannung mit einem vorgegebenen Sollwert $U_t$ (z.B. 500 Volt) generiert wird. Die Testspannung wird an das zu testende HV-System 2 bzw. die zu testende Komponente 2 zwischen den Messkontakten 31, 32 angelegt und bewirkt einen Messstrom $i_m$. Um den Messstrom $i_m$ zu messen, weist das Messsystem 1 ein Strommessgerät A auf, welches in Serie zur Spannungsquelle 4 angeordnet ist. Weiterhin weist das Messsystem 1 ein Spannungsmessgerät V auf, welche parallel zur Spannungsquelle 4 angeordnet ist. Mit dem Spannungsmessgerät V kann beispielsweise eine jeweils aktuell am zu testenden HV-System 2 bzw. an der zu testenden HV-Komponente 2 anliegende Messspannung $u_m$ gemessen werden.

Wenn die Testspannung auf den vorgegebenen Sollwert $U_t$ hochläuft und die Kapazität C des HV-Systems 2 bzw. der HV-Komponente 2 dadurch geladen wird (d.h., durch die Testspannung aufgeladen oder entladen wird), teilt sich der Messstrom $i_m$ - wie in Figur 1 beispielhaft dargestellt - in einen Ladestrom $i_c$ und in einen Leckstrom $i_r$ auf. Im Idealfall klingt der Ladestrom $i_c$ mit steigender elektrischer Ladung der Kapazität C ab und hat bei voll aufgeladener Kapazität C einen Wert von Null, sodass dann der Messstrom $i_m$ weitgehend dem Leckstrom $i_r$ entspricht. Dabei hat in einer Messphase MP die Testspannung im Idealfall den vorgegebenen Sollwert $U_t$ erreicht und weist diesen konstant auf, sodass eine Spannung mit diesem Sollwert $U_t$ am zu testenden HV-System 2 bzw. an der zu testenden Komponente 2 anliegt. Das Einreichen des Sollwerts $U_t$ der Testspannung am zu testenden HV-System 2 bzw. an der zu testenden Komponente 2 kann z.B. mit Hilfe der vom Spannungsmessgerät V gemessenen Messspannung $u_m$ festgestellt werden. Der in der Messphase MP gemessene Messstrom $i_m$ kann dann für die Ermittlung des Isolationswiderstands R - idealerweise nach dem Ohm'schen Gesetz - herangezogen werden.

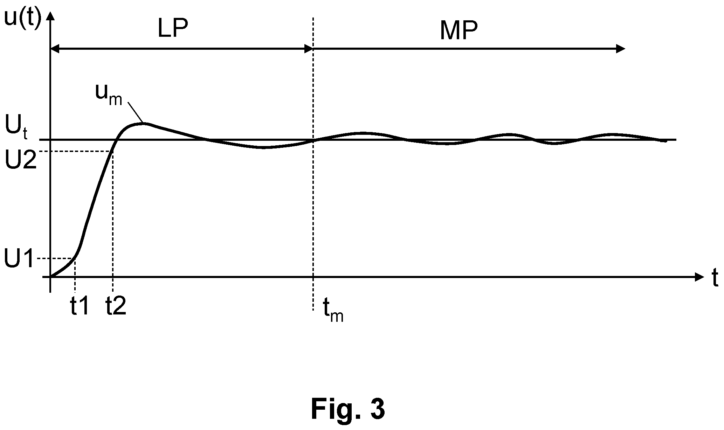

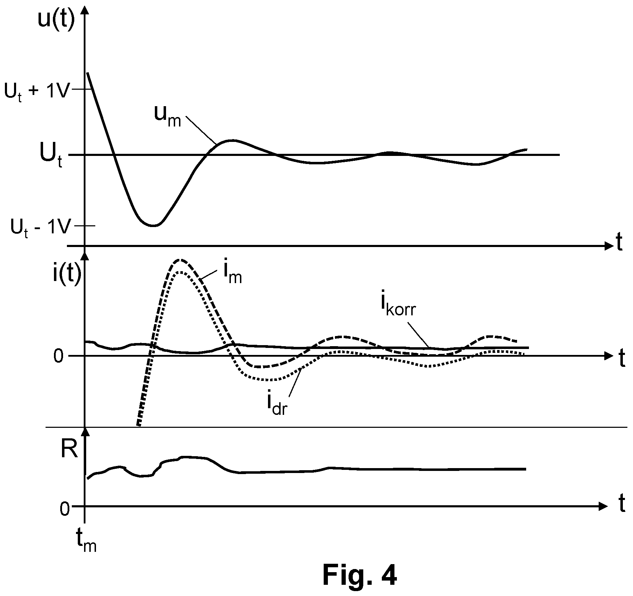

In einem realen Messsystem 1, vor allem bei Verwendung einer geregelten Spannungsquelle 4 bzw. eines Spannungsreglers als Spannungsquelle 4, kann die Spannungsquelle 4 langsame Drifts und Schwankungen $u_{dr}$ aufweisen. Diese sind in Figur 1 beispielhaft durch eine Wechselspannungsquelle bzw. Driftspannung $u_{dr}$ dargestellt. Die Drifts und Schwankungen $u_{dr}$ werden z.B. in der Regel durch ein niederfrequentes Rauschen (z.B. im Bereich von ca. 1 Hertz) in einer Rückkopplung der Regelung der Spannungsquelle 4 verursacht, sodass die Testspannung auch in der Messphase MP mit sehr geringen Abweichungen $u_{dr}$ um den vorgegebenen Sollwert $U_t$ schwankt - wie in der Folge noch anhand der Figuren 3 und 4 beispielhaft gezeigt wird. Insbesondere bei einer relativ großen Kapazität C (z.B. im Bereich von ca. 1 μFarad oder größer) im HV-System 2 bewirkt die Driftspannung $u_{dr}$ weiterhin - auch nach Laden bzw. Umladen der Kapazität C im HV-System 2 bzw. in der Messphase MP - relativ große kapazitive Ladeströme $i_c$, welche den gemessenen Messstrom $i_m$ verfälschen. Da insbesondere bei einem sehr großem Isolationswiderstand R, beispielsweise im Megaohm-Bereich, der Leckstrom $i_r$ relativ klein ist, kann der relativ kleine Leckstrom $i_r$ von den kapazitiven Ladeströmen $i_c$ überdeckt werden, wodurch es zu einer fehlerhaften Ermittlung des Isolationswiderstands R kommen kann.

Um einen Einfluss der Ladeströme $i_c$ zu kompensieren, weist das Messsystem 1 eine Auswerteeinheit 5 auf. Die Auswerteeinheit 5 kann wie eine Messwerterfassung durch das Strommessgerät A und durch das Spannungsmessgerät V Mikrokontroller basiert ausgeführt sein. Die Auswerteeinheit 5 ist dazu eingerichtet, während des Hochlaufens LP der Testspannung auf den vorgegebenen konstanten Sollwert $U_t$ die elektrische Ladung des zu testenden Hochvolt-Systems 2 und/oder der zu testenden Komponente 2 zwischen einem ersten Spannungswert U1 der Messspannung $u_m$ und einem zweiten Spannungswert U2 der Messspannung $u_m$ durch Aufintegrieren des weitgehend simultan zur Messspannung $u_m$ gemessenen Messstroms $i_m$ zu ermitteln und daraus einen Wert der Kapazität C abzuschätzen. Weiterhin ist die Auswerteeinheit 5 dazu eingerichtet, während der Messphase MP - d.h. nach Erreichen des Sollwerts $U_t$ durch die Testspannung - aus dem ermittelten Kapazitätswert C und einer zeitlichen Abweichung der vom Spannungsmessgerät V gemessenen Messspannung $u_m$ vom vorgegebenen konstanten Sollwert $U_t$ der Testspannung ein Korrekturstrom $i_{dr}$ zu ermitteln. Dieser Korrekturstrom $i_{dr}$ wird von der Auswerteeinheit 5 verwendet, um den vom Strommessgerät A gemessenen Messstroms $i_m$ zu korrigieren. Außerdem ist die Auswerteeinheit 5 dazu eingerichtet, aus dem korrigierten Messstrom $i_{korr}$ den Isolationswiderstand abzuleiten. Die Auswerteeinheit 5 erhält dazu die jeweils aktuell gemessenen Werte des Messtroms $i_m$ vom Strommessgerät A sowie die jeweils aktuell gemessenen Werte der Messspannung $u_m$ vom Spannungsmessgerät V. Die Messung des Messstrom $i_m$ durch das Strommessgerät A und die Messung der Messspannung $u_m$ durch das Spannungsmessgerät V können dazu z.B. kontinuierlich oder mittels zeitlich diskreter Abtastung erfolgen.

Weiterhin kann eine Anzeigeeinheit 6 vorgesehen sein, auf welcher zumindest der aus dem korrigierten Messstrom $i_{korr}$ abgeleitete Isolationswiderstand R darstellbar ist. Der Isolationswiderstand R kann dabei z.B. absolut in Megaohm und/oder als gemessener Widerstand R bezogen auf die Spannung in Ω/V angegeben werden. Zusätzlich könnte auf der Anzeigeeinheit 6 auch eine Bewertung des gemessenen Isolationswiderstands R (z.B. Isolationswiderstand R ausreichend; Isolationswiderstand R zu klein, etc.) angegeben werden.

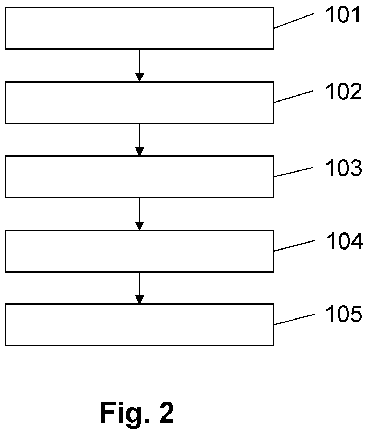

In Figur 2 ist beispielhaft ein Ablauf des Verfahrens zum Ermitteln eines Isolationswiderstands R in einem Hochvolt-System 2 dargestellt. Dazu wird für die Durchführung des Verfahrens das Messsystem 1 mit dem zu testenden HV-System 2 oder mit der zu testenden Komponente des HV-Systems 2 über die Messkontakte 31, 32 verbunden. Über die Messkontakte 31, 32 wird die von der Spannungsquelle 4 des Messsystems 1 generierte Testspannung an das zu testende HV-System 2 bzw. an die zu testende Komponente angelegt. Die Testspannung wird auf den vorgegebenen Sollwert $U_t$ hochgefahren, welcher in der Messphase MP erreicht wird und bis auf relativ kleine Abweichungen durch die Driftspannung $u_{dr}$ gehalten wird. Die Testspannung ruft einen Messstrom $i_m$ hervor, welcher vom Strommessgerät A des Messsystems 1 kontinuierlich oder mittels zeitdiskreter Abtastung gemessen werden kann. Weitgehend simultan wird die aktuell am zu testenden HV-System 2 bzw. an der zu testenden Komponente anliegende Messspannung $u_m$ vom Spannungsmessgerät V des Messsystems 1 gemessen, wodurch überprüft werden kann, wann der Sollwert $U_t$ der Testspannung von der am zu testenden HV-System 2 bzw. der zu testenden Komponente erreicht und weitgehend - bis auf die Abweichungen durch die Spannungsdrift $u_{dr}$ - gehalten wird und die Messphase MP beginnen kann.

In einem ersten Ermittlungsschritt 101 wird während beim Hochlaufen der Testspannung auf den vorgegebenen Sollwert $U_t$ in der Auswerteeinheit 5 die elektrische Ladung des zu testenden Hochvolt-System 2 bzw. der zu testenden Komponente ermittelt. D.h., es wird z.B. die Aufladung eines nicht geladenen Hochvolt-Systems 2 bzw. einer zu testenden Komponente durch Anlegen der Testspannung ermittelt. Alternativ, könnte auch ein Entladen bzw. eine Änderung der Ladung eines aufgeladenen Hochvolt-Systems 2 bzw. einer zu testenden Komponente durch Anlegen der Testspannung ermittelt werden. Dazu wird der gemessene Messstrom $i_m$ beispielsweise zwischen zwei vorgegebenen Spannungswerten U1, U2 aufintegriert. Als erster Spannungswert U1, bei welchem mit der Integration des Messstroms $i_m$ begonnen wird, können z.B. 20% des Sollwerts $U_t$ der Testspannung verwendet werden. Als zweiter Spannungswert U2, bei welchem die Integration des Messstroms $i_m$ wieder beendet wird, können z.B. 90% des Sollwert $U_t$ der Testspannung vorgesehen sein. Die elektrische Ladung Q des zu testenden Hochvolt-System 2 bzw. der zu testenden Komponente ergibt sich dann beispielsweise durch folgende Formel (1).

$$(1) \quad Q = \int_{t1}^{t2} i(t)dt,$$

wobei i(t) dem gemessene Messstrom $i_m$ bzw. einer Abfolge von zeitdiskret abgetasteten Messwerten des Messstrom $i_m$ beim Hochlaufen der Testspannung entspricht. Die Zeitpunkte t1, t2, zwischen welchen der Strom $i_m$ aufintegriert wird, entsprechen den Zeitpunkten t1, t2 an welchen die Messspannung $u_m$ die vorgegebenen Spannungswerte U1, U2 erreicht.

Dies beispielsweise aus der Figur 3 ersichtlich, welche einen zeitlichen Verlauf der Messspannung $u_m$ während der Durchführung des Verfahrens beispielhaft zeigt, wobei beispielsweise von einem nicht geladenen zu testenden HV-System 2 bzw. einer zu testenden Komponente mit einer relativ großen Kapazität C (z.B. 1 μFarad) und einem parallelen Widerstand R im hochohmigen Bereich (z.B. 1 GΩ) ausgegangen wurde. Dazu ist auf der x-Achse die Zeit t in Sekunden und auf der y-Achse die Spannung U (z.B. in Volt) dargestellt. Auf der y-Achse ist weiterhin der vorgegebene konstante Sollwert $U_t$ der Testspannung eingetragen. Dieser kann z.B. 500 V betragen. Während des Hochlaufens LP wird die Testspannung auf den Sollwert $U_t$ hochgefahren. Idealerweise wird beim Hochlaufen LP der Testspannung eine zeitliche Änderung - d.h. ein du(t)/dt - der am zu testenden HV-System 2 bzw. an der zu testenden Komponente anliegenden Spannung, welche der Messspannung $u_m$ entspricht, begrenzt und das zu testende HV-System 2 bzw. die zu testende Komponente z.B. mit einem limitierten, idealerweise konstanten Strom aufgeladen. Wird an einem Zeitpunkt $t_m$ der Sollwert $U_t$ erreicht und bis auf die Abweichungen durch die Spannungsdrift $u_{dr}$ konstant gehalten, so wird mit der Messphase MP begonnen. D. h., die Messphase MP beginnt, wenn die Spannungsschwankungen unter eine vorgegebene Schwelle gesunken sind bzw. die Testspannung entsprechend eingeregelt ist.

In Figur 3 ist auch beispielhaft der erste Spannungswert U1 (z.B. 20% des Sollwerts $U_t$ der Testspannung) eingetragen, welcher zu einem Zeitpunkt t1 vom Spannungsmessgerät V gemessen wird. Bei diesem Spannungswert U1 bzw. zu diesem Zeitpunkt t1 beginnt die Auswerteeinheit 5 den gemessenen Messstrom $i_m$ aufzuintegrieren. Weiterhin ist in Figur 3 auch der zweite Spannungswert U2 (z.B. 90% des Sollwerts $U_t$ der Testspannung) eingetragen. Dieser wird zum Zeitpunkt t2 erreicht und die Auswerteeinheit 5 beendet zu diesem Zeitpunkt t2 die Aufintegration des gemessenen Messstroms $i_m$, um die Ladung Q des zu testenden HV-Systems 2 bzw. der zu testenden Komponente zu ermitteln.

In einem Abschätzschritt 102 wird dann aus der ermittelten Ladung Q des zu testenden HV-Systems 2 bzw. der zu testenden Komponente ein Wert für die Kapazität C des zu testenden HV-Systems 2 bzw. der zu testenden Komponente abgeschätzt. Dies erfolgt unter Vernachlässigung des (relativ kleinen) Leckstroms $i_r$ über den Isolationswiderstand R beispielsweise nach den folgenden Formeln (2a) und (2b):

$$(2a) \quad \Delta u = u(t2) - u(t1) = U2 - U1$$

$$(2b) \quad C = Q/_{\Delta u}$$

Δu entspricht dabei einer Differenz zwischen dem ersten und dem zweiten Spannungswert U1, U2 bzw. den an den Zeitpunkten t1, t2 gemessenen Werte u(t1), u(t2) der

Messspannung $u_m$. Der Kapazitätswert C wird dann durch Division der im ersten Ermittlungsschritt 101 ermittelten elektrischen Ladung Q durch die Spannungsdifferenz $\Delta u$ bestimmt.

Alternativ bzw. für eine genauere Bestimmung der Kapazität C kann die Ermittlung der Ladung im ersten Ermittlungsschritt 101 auch über zwei Spannungsbereiche durchgeführt werden. Dies kann vor allem von Interesse sein, wenn z.B. kein rein kapazitives bzw. kein weitgehend kapazitives zu testendes HV-System 2 vorliegt. Dabei könnte z.B. ein relativ großer Anteil des gemessenen Stroms $i_m$ bzw. der ermittelten Ladung Q auch durch einen Strom über zur Kapazität C parallelen (eher niederohmigen) Widerstand im HV-System 2 verursacht sein. Dazu wird z.B. neben dem ersten und dem zweiten Spannungswert U1, U2 eine weiterer, dritter Spannungswert U3 vorgegeben, welcher größer als der erste Spannungswert U1 und kleiner als der zweite Spannungswert U2 ist. Der dritte Spannungswert U3 könnte z.B. bei 50% des Sollwerts $U_t$ der Testspannung liegen. Im ersten Ermittlungsschritt 101 werden dann gemäß der oben angeführten Formel (1) eine elektrische Ladung zwischen dem ersten und dem dritten Spannungswert U1, U3 und eine elektrische Ladung zwischen dem dritten und dem zweiten Spannungswert U3, U2 bestimmt. Dazu wird jeweils der Messstrom $i_m$ zwischen den Zeitpunkten, an denen der erste und dritte Spannungswert U1, U3 bzw. der dritte und der zweite Spannungswert U3, U2 vom Spannungsmessgerät V gemessen wird, aufintegriert.

Im Abschätzschritt 102 wird dann jeweils aus den für die beiden Spannungsbereich - d.h. dem Bereich zwischen ersten und dritten Spannungswert U1, U3 und dem Bereich zwischen dritten und zweiten Spannungswert U3, U2 - ermittelten Ladungswerten ein Kapazitätswert C des zu testenden HV-System 2 bzw. der zu testenden Komponente abgeschätzt. Die abgeschätzten Kapazitätswerte C werden dann miteinander verglichen. Sind die beiden abgeschätzten Kapazitätswerte C annähernd ident, so liegt ein weitgehend kapazitives HV-System 2 bzw. eine weitgehend kapazitive Komponente vor. Der im Abschätzschritt 2 mittels eines der beiden Spannungsbereiche abgeschätzte Kapazitätswert C kann dann für einen weiteren Verlauf des Verfahrens verwendet werden. Weichen die beiden im Abschätzschritt 102 abgeschätzten Kapazitätswerte C signifikant voneinander ab, so liegt kein rein kapazitives bzw. kein weitgehend kapazitives zu testendes HV-System 2 vor. Für den weiteren Verlauf des Verfahrens kann beispielsweise ein arithmetisches Mittel der beiden abgeschätzten Kapazitätswerte C verwendet werden. Zusätzlich kann die Abschätzung des Kapazitätswerts C mit Hilfe von zwei Spannungsbereich auch genutzt werden, um die Spannungsquelle 4 besser auf das zu testende HV-System 2 bzw. die zu testende Komponente einzustellen bzw. einzuregeln.

In einem zweiten Ermittlungsschritt 103 wird dann während der Messphase MP in der Auswerteeinheit 5 aus dem im Abschätzschritt 102 abgeschätzten Kapazitätswert C und aus einer zeitlichen Abweichung der gemessenen Messspannung $u_m$ vom vorgegebenen Sollwert $U_t$ der Testspannung ein Korrekturstrom $i_{dr}$ ermittelt. Die Messphase MP beginnt - wie z.B. in Figur 3 beispielhaft dargestellt - an einem Zeitpunkt $t_m$, an welchem der Sollwert $U_t$ erreicht und bis auf die Abweichungen durch die Spannungsdrift $u_{dr}$ konstant gehalten wird. Der Korrekturstrom $i_{dr}$ wird dabei entsprechend der folgenden Formel (3) ermittelt.

$$(3) \quad i_{dr}(t) = C * {du(t)}/{dt}$$

Dabei ist C der abgeschätzte Kapazitätswert C und u(t) entsprecht der gemessenen Messspannung $u_m$, welche vom Spannungsmessgerät V z.B. kontinuierlich oder in Form von zeitdiskret abgetasteten Messwerten ermittelt werden kann. du(t)/dt repräsentiert dann die Abweichung der gemessenen Messspannung $u_m$ vom vorgegebenen konstanten Sollwert der Testspannung bzw. die Spannungsdrift $u_{dr}$. Der so von der Auswerteeinheit 5 ermittelte Korrekturstrom $i_{dr}$ wird dann dazu verwendet, um den gemessenen Messstrom $i_m$ zu korrigieren. Gemäß der Formel (4) ergibt sich damit ein korrigierte Messstrom $i_{korr}$ als Differenz aus gemessenem Messstrom $i_m$ und ermittelten Korrekturstrom $i_{dr}$.

$$(4) \quad i_{korr}(t) = i_m(t) - i_{dr}(t)$$

In einem Ableitschritt 104 wird dann von der Auswerteeinheit 5 aus dem korrigierten Messstrom $i_{korr}$ und der gemessenen Messspannung $u_m$ der Isolationswiderstand R abgeleitet. Dazu kann z.B. das Ohm'sche Gesetz herangezogen werden, wobei beispielweise die gemessene Messspannung $u_m$ durch den jeweils aktuell ermittelten Wert des Korrekturstroms $i_{korr}$ dividiert wird. Die Einzelergebnisse dieser Widerstandsermittlung können dann noch gefiltert bzw. gemittelt werden.

Zeitliche Verläufe der gemessenen Messspannung $u_m$, des gemessenen Messstrom $i_m$, des Korrekturstrom $i_{korr}$ und des korrigierten Messstrom $i_{dr}$ während der Messphase bzw. während des zweiten Ermittlungsschritt 103 und des Ableitschritts 104 sind beispielhaft in Figur 4 dargestellt. Dabei wurde beispielsweise von einem zu testenden HV-System 2 bzw. einer zu testenden Komponente 2 mit einer relativ großen Kapazität C (z.B. 1 $\mu$Farad) und einem parallelen Widerstand R im hochohmigen Bereich (z.B. 1 G$\Omega$) ausgegangen. Weiterhin zeigt Figur 4 beispielhaft einen zeitlichen Verlauf des im Ableitschritt 104 aus dem korrigierten Messstrom $i_{korr}$ abgeleiteten Widerstands R. Dabei zeigt der erste zeitliche Verlauf eine vergrößerte Darstellung des beispielhaften, zeitlichen Verlaufs der Messspannung $u_m$ aus Figur 3, um vor allem die Abweichungen aufgrund der Spannungsdrift $u_{dr}$ besser sichtbar zu machen. Der zweite zeitliche Verlauf zeigt den zeitlichen Verlauf des gemessenen Messstrom $i_m$, des Korrekturstrom $i_{dr}$ und des

korrigierten Messstrom $i_{korr}$, wobei auf der x-Achse wieder die Zeit t in Sekunden aufgetragen ist. Auf der y-Achse ist der Strom i (z.B. in $\mu$Ampere) aufgetragen. So ist aus Figur 4 auch ersichtlich, dass der Verlauf des ursprünglich gemessenen Messstrom $i_m$ Schwankungen aufweisen kann, welche größer als der mittlere gemessene Strom selbst sind. Der berechnete Stromanteil $i_{dr}$ kann diese Schwankungen - verursacht durch die Driftspannung $u_{dr}$ der Spannungsquelle 4 - effektiv reduzieren, wie aus dem Verlauf des korrigierten Messstrom $i_{korr}$ ersichtlich ist. Der dritte Verlauf zeigt dann einen zeitlichen Verlauf des abgeleiteten Widerstands R, wobei auf der y-Achse z.B. in G$\Omega$ aufgetragen sind.

Nach dem Ableitschritt 104 kann dann der abgeleitete Isolationswiderstand R in einem Ausgabeschritt 105 beispielsweise auf einer Anzeigeeinheit 6 ausgegeben werden. Dies kann z.B. als Darstellung in Form eines Widerstandswerts in Megaohm und/oder bezogen auf die Spannung in Ohm/Volt erfolgen. Weiterhin kann auf der Anzeigeeinheit 6 im Ausgabeschritt 105 noch eine Bewertung des abgeleiteten Isolationswiderstands R (z.B. Isolationswiderstand R ausreichend, Isolationswiderstand R zu klein, etc.) ausgegebenen und angezeigt werden.

**Patentansprüche**

1.  Verfahren zum Ermitteln eines Isolationswiderstands (R) in einem Hochvolt-System (2), wobei eine Testspannung mit einem vorgegebenen konstanten Sollwert ($U_t$) an das zu testende Hochvolt-System (2) und/oder eine zu testende Komponente angelegt wird, und wobei ein durch die Testspannung hervorgerufener Messstrom ($i_m$) und eine aktuell am zu testenden Hochvolt-System (2) und/oder an der zu testenden Komponente anliegende Messspannung ($u_m$) gemessen werden, *dadurch gekennzeichnet, dass* während eines Hochlaufens der Testspannung auf den vorgegebenen konstanten Sollwert ($U_t$) eine elektrische Ladung des zu testenden Hochvolt-Systems (2) und/oder der zu testenden Komponente ermittelt wird (101), *dass* aus der ermittelten Ladung ein Kapazitätswert (C) für das zu testenden Hochvolt-System (2) und/oder die zu testenden Komponente abgeschätzt wird (102), *dass* während einer Messphase (MP) aus dem abgeschätzten Kapazitätswert (C) und aus einer zeitlichen Abweichung der gemessenen Messspannung ($u_m$) vom vorgegebenen Sollwert ($U_t$) der Testspannung ein Korrekturstrom ($i_{dr}$) ermittelt wird (103), mit welchem der jeweils gemessene Messstrom ($i_m$) korrigiert wird, *und dass* aus dem korrigierten Messstrom ($i_{korr}$) und der gemessenen Messspannung ($u_m$) der Isolationswiderstand (R) abgeleitet wird (104).

2.  Verfahren nach Anspruch 1, *dadurch gekennzeichnet, dass* die elektrische Ladung des zu testenden Hochvolt-Systems (2) und/oder der zu testenden Komponente durch Aufintegrieren des gemessenen Messstroms ($i_m$) ermittelt wird (101).

3.  Verfahren nach Anspruch 1 oder Anspruch 2, *dadurch gekennzeichnet, dass* für ein Abschätzen des Kapazitätswerts (C) des zu testenden Hochvolt-Systems (2) und/oder der zu testenden Komponente ein erster und ein zweiter Spannungswert (U1, U2) der Messspannung ($u_m$) vorgegebenen werden, zwischen welchen die elektrische Ladung des zu testenden Hochvolt-Systems (2) und/oder der zu testenden Komponente ermittelt wird (101).

4.  Verfahren nach Anspruch 3, *dadurch gekennzeichnet, dass* für das Abschätzen des Kapazitätswerts (C) des zu testenden Hochvolt-Systems (2) und/oder der zu testenden Komponente ein dritter Spannungswert (U3) der Messspannung ($u_m$) vorgegeben wird, welcher größer als der erste Spannungswert (U1) der Messspannung ($u_m$) und kleiner als der zweite Spannungswert (U2) der Messspannung ($u_m$) ist, wobei jeweils die elektrische Ladung des zu testenden Hochvolt-Systems (2) und/oder der zu testenden Komponente zwischen dem ersten und dem dritten Spannungswert (U1, U3) und die elektrische Ladung des zu testenden Hochvolt-System (2) und/oder der zu testenden Komponente zwischen dem dritten und dem zweiten Spannungswert (U3, U2) ermittelt wird (101), und wobei jeweils aus den ermittelten Aufladungen einer Kapazitätswert (C) des zu testenden Hochvolt-Systems (2) und/oder der zu testende Komponente abgeschätzt wird (102).

5.  Verfahren nach einem der Ansprüche 1 bis 4, *dadurch gekennzeichnet, dass* zumindest der abgeleitete Isolationswiderstand (R) ausgegebenen und dargestellt wird (105).

6.  Verfahren nach einem der Ansprüche 1 bis 5, *dadurch gekennzeichnet, dass* eine Messung des Messstroms ($i_m$) und eine Messung der Messspannung ($u_m$) simultan durchgeführt wird.

7.  Verfahren nach einem der Ansprüche 1 bis 6, *dadurch gekennzeichnet, dass* während des Hochlaufens der Testspannung auf den vorgegebenen konstanten Sollwert ($U_t$) eine zeitliche Änderung der am zu testenden Hochvolt-System (2) und/oder an der zu testenden Komponente anliegenden Messspannung ($u_m$) beim Hochlaufen der Testspannung auf den vorgegebenen Sollwert ($U_t$) begrenzt wird (101).

8.  Verfahren nach einem der Ansprüche 1 bis 7, *dadurch gekennzeichnet, dass* die Messung des Messstroms ($i_m$) und/oder der Messspannung ($u_m$)

kontinuierlich erfolgt.

9. Verfahren nach einem der Ansprüche 1 bis 7, *dadurch gekennzeichnet, dass* die Messung des Messstroms ($i_m$) und/oder der Messspannung ($u_m$) mittels zeitdiskreter Abtastung durchgeführt wird.

10. Messsystem (1) zum Ermitteln eines Isolationswiderstands (R) in einem Hochvolt-System (2), wobei das Messsystem (1) mit dem zu testenden Hochvolt-System (2) und/oder mit einer zu testenden Komponente des Hochvolt-Systems (2) verbindbar ist, und wobei das Messsystem (1) zumindest eine Spannungsquelle (4) zum Generieren einer Testspannung mit einem vorgegebenen konstanten Sollwert (Ut), ein Strommessgerät (A) zum Messen eines durch die Testspannung hervorgerufenen Messstrom ($i_m$) und ein Spannungsmessgerät (V) zum Messen einer am zu testenden Hochvoltsystem (2) und/oder der zu testenden Komponente anliegenden Messspannung ($u_m$) aufweist, *dadurch gekennzeichnet, dass* das Messystem (1) weiterhin eine Auswerteeinheit (5) aufweist, welche dazu eingerichtet ist, während eines Hochlaufens der Testspannung auf den vorgegebenen konstanten Sollwert ($U_t$) eine elektrische Ladung des zu testenden Hochvolt-Systems (2) und/oder der zu testenden Komponente zu ermitteln und aus der ermittelten Ladung einen Kapazitätswert (C) des zu testenden Hochvolt-Systems (2) und/oder der zu testenden Komponente abzuschätzen, und welche weiterhin dazu eingerichtet ist, während einer Messphase (MP) aus dem ermittelten Kapazitätswert (C) und aus einer zeitlichen Abweichung der vom Spannungsmessgerät (V) gemessenen Messspannung ($u_m$) vom vorgegebenen konstanten Sollwert ($U_t$) der Testspannung ein Korrekturstrom ($i_{dr}$) zum Korrigieren des vom Strommessgerät (A) gemessenen Messstroms ($i_m$) zu ermitteln und aus dem korrigierten Messstrom ($i_{korr}$) und der gemessenen Messspannung ($u_m$) den Isolationswiderstand (R) abzuleiten.

11. Messsystem nach Anspruch 10, *dadurch gekennzeichnet, dass* eine Anzeigeeinheit (6) vorgesehen ist, über welche zumindest der aus dem korrigierten Messstrom ($i_{korr}$) abgeleitete Isolationswiderstand (R) darstellbar ist.

12. Messsystem nach einem der Ansprüche 10 bis 11, *dadurch gekennzeichnet, dass* eine Messwerterfassung durch das Strommessgerät (A) und durch das Spannungsmessgerät (V) sowie die Auswerteeinheit (5) Mikrokontroller basiert ausgestaltet sind.

**Fig. 1**

EP 4 628 905 A1

Fig. 2

**Fig. 3**

EP 4 628 905 A1

**Fig. 4**

EP 4 628 905 A1

Europäisches
Patentamt

European
Patent Office

Office européen
des brevets

# EUROPÄISCHER RECHERCHENBERICHT

Nummer der Anmeldung

EP 25 16 4069

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A | EP 0 654 673 B1 (WALTHER BENDER GMBH & CO KG DI [DE]) 10. Juli 2002 (2002-07-10) * Zusammenfassung; Abbildungen 1-9 * * Absätze [0002] - [0010] *<br>- - - - - | 1-12 | INV.<br>G01R27/02<br>G01R27/08 |
| A | DE 10 2021 101693 B3 (BENDER GMBH & CO KG [DE]) 15. Juni 2022 (2022-06-15) * Zusammenfassung; Abbildungen 1-10d * * Absätze [0004] - [0011] *<br>- - - - - | 1-12 | |

RECHERCHIERTE
SACHGEBIETE (IPC)

G01R

Der vorliegende Recherchenbericht wurde für alle Patentansprüche erstellt

| Recherchenort | Abschlußdatum der Recherche | Prüfer |
|---|---|---|
| München | 21. August 2025 | Kleiber, Michael |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus anderen Gründen angeführtes Dokument
........................................................................
& : Mitglied der gleichen Patentfamilie, übereinstimmendes
    Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 25 16 4069

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

21-08-2025

| Im Recherchenbericht angeführtes Patentdokument | Datum der Veröffentlichung | Mitglied(er) der Patentfamilie | | Datum der Veröffentlichung |
|---|---|---|---|---|
| EP 0654673 B1 | 10-07-2002 | AT | E220462 T1 | 15-07-2002 |
| | | DE | 4339946 A1 | 01-06-1995 |
| | | DK | 0654673 T3 | 04-11-2002 |
| | | EP | 0654673 A1 | 24-05-1995 |
| | | ES | 2179834 T3 | 01-02-2003 |
| | | PT | 654673 E | 29-11-2002 |
| DE 102021101693 B3 | 15-06-2022 | KEINE | | |

Für nähere Einzelheiten zu diesem Anhang : siehe Amtsblatt des Europäischen Patentamts, Nr.12/82

EPO FORM P0461